# FASCICULE DE BREVET EUROPEEN

(11) **EP 0 819 989 B1**
(45) Date de publication et mention de la délivrance du brevet: **02.03.2005**
(21) Numéro de dépôt: 97470012.2
(22) Date de dépôt: 14.05.1997
(51) Int. Cl.: G03F 7/30, G03F 7/40

(54) **Procédé pour la confection automatique de manchons d'impression**
Verfahren zur automatisierten Herstellung von Druckhülsen
Process for an automated production of printing sleeves

(30) Priorité: 19.07.1996 FR 9609349
(43) Date de publication de la demande: 21.01.1998
(73) Titulaire: PHOTOMECA / EGG, 54340 Pompey (FR)
(72) Inventeur: Ferrante, Mario, 54520 Laxou (FR)
(74) Mandataire: Poupon, Michel

(56) Documents cités:
- DE-A- 4 307 923
- FR-A- 2 695 738
- GB-A- 2 243 459
- US-A- 4 108 683

## Description

La présente invention a pour objet un procédé pour la confection de manchons d'impression supportant des plaques photopolymères pour utilisation comme formes imprimantes dans des techniques d'impression comme par exemple en flexographie ou en offset sec ; l'invention a également pour objet un dispositif de mise en oeuvre du procédé.

On sait déjà que l'on peut obtenir un cliché pour la flexographie en exposant une plaque photopolymère sensible au rayonnement ultraviolet, avec l'interposition d'un film négatif qui laisse exposées au rayonnement les zones qui doivent venir en relief sur le cliché terminé.

Ces dernières années, les techniques d'impression ont évoluées de plus en plus vers une utilisation accrue de manchons ou de cylindres d'impression.

Ceci est dû en grande partie aux dernières technologies permettant aujourd'hui d'impressionner des plaques ou des clichés photopolymères directement par laser, ledit laser évoluant sur un axe horizontal parallèle à l'axe de rotation du manchon d'impression, ledit manchon tournant autour de son axe.

Dans la suite de la description, on définira par manchon d'impression une plaque ou un cliché photopolymère monté sur un cylindre d'impression.

On trouve actuellement sur le marché des machines et des procédés qui permettent manuellement de développer des manchons d'impression montés sur cylindre expansible.

Chaque phase d'impression nécessite l'utilisation d'un manchon d'impression différent, ce qui entraîne des manipulations longues et fastidieuses pour préparer les manchons, lesdites manipulations étant le plus souvent effectuées manuellement.

Les dispositifs utilisant des manchons d'impression sont donc d'une mise en oeuvre onéreuse au niveau de la fabrication et ne donnent en outre pas toute satisfaction au niveau des résultats en raison des contraintes exposées précédemment, à savoir leur côté manuel et fastidieux.

Un premier but de l'invention est d'automatiser complètement l'ensemble du procédé pour la confection de manchons d'impression.

Un autre but de l'invention est de confectionner des manchons d'impression de tout format dans une machine complètement automatique et hermétique à toute vapeur de solvant.

Pour atteindre ces buts, plusieurs problèmes ont dû être résolus et notamment :
- avoir une machine en ligne dont l'encombrement au sol soit le minimum,
- avoir un ensemble complètement hermétique aux vapeurs de solvant,
- montage des manchons sur axe de transport dans les différentes phases de développement et pour n'importe quel diamètre et longueur de manchon d'impression.

Conformément à l'invention ces résultats sont atteints par un dispositif pour la fabrication de clichés photopolymères montés sur cylindres, définis par manchon d'impression, pour la réalisation d'impression en flexographie et en offset sec, comportant les postes suivants,
- un magasin de stockage qui reçoit des manchons d'impression préalablement exposés à un rayonnement UVA,
- un dispositif de gravure,
- un dispositif de séchage,
- un poste de stockage des manchons d'impression terminés,
caractérisé en ce qu'il comporte en outre disposés l'un après l'autre en ligne, d'une part en amont du poste de gravure - un sas anti-vapeur de solvant, et d'autre part des axes où sont fixés les manchons d'impression, lesdits axes permettant leur maintien en rotation durant les différentes étapes de leur fabrication des manchons d'impression et leur transfert et ce quelque soit leur diamètre et leur longueur.

Préférentiellement le dispositif comporte un poste de finition constitué de tubes UVA et UVC placés au-dessus et au-dessous du manchon d'impression, dans lequel le manchon est en rotation autour de son axe fin de permettre une insolation uniforme.

L'invention concerne également un procédé pour la fabrication de clichés photopolymères préalablement exposés à un rayonnement UVA et montés sur des cylindres d'impression, l'ensemble (clichés photopolymères + cylindres d'impression) étant appelé manchon d'impression, pour la réalisation d'impression en flexographie et en offset sec, ledit procédé comportant les étapes suivantes séquentiellement :
- une étape d'aspiration des vapeurs de solvants,
- une étape de gravure par brossage et trempage dans un solvant ou un mélange d'eau plus additif,
- une étape de séchage par passage dans un four dynamique à air chaud pulsé,
caractérisé en ce qu'il comporte en outre un transfert de manchon entre deux étapes successives et une étape de finition par exposition à des rayonnements UVA et UVC consistant à placer au-dessus et au-dessous du manchon d'impression les rayonnements et simultanément mettre en rotation autour de son axe le manchon.

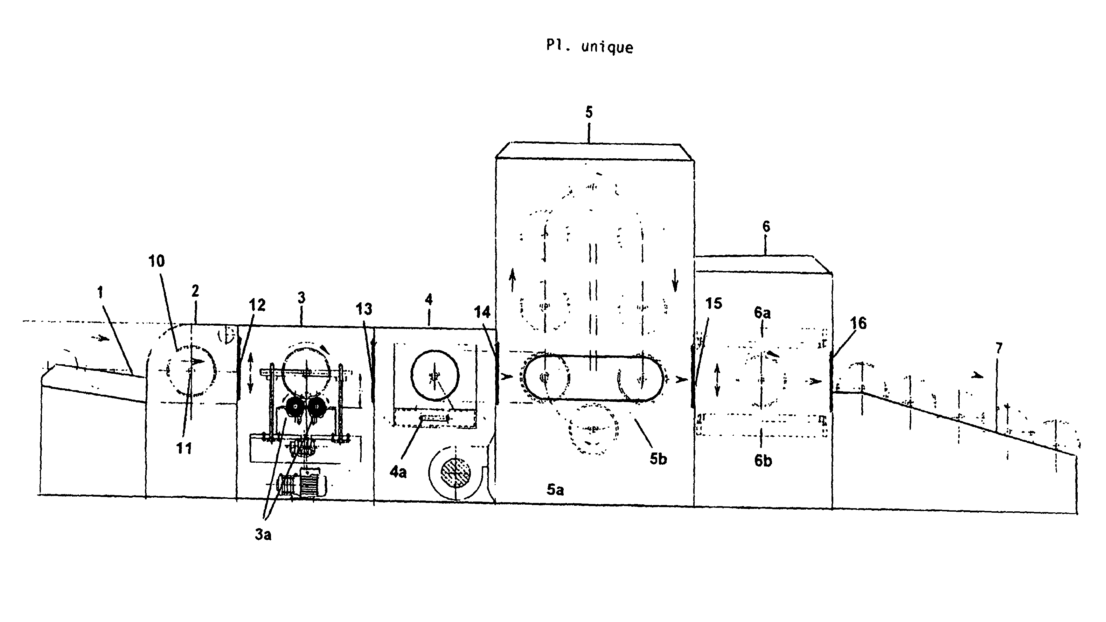

On comprendra mieux l'invention à l'aide de la description qui suit faite en référence à la figure unique annexée qui est un schéma de principe d'un exemple non limitatif de mise en oeuvre du procédé.

Les clichés photopolymères préalablement fixés par un collant double-face sur les manchons (10) sont exposés par rayon laser ou en méthode traditionnelle par film négatif sur insoleuse rotative à un rayonnement UVA.

Un magasin de stockage (1) reçoit les manchons (10) préalablement exposés à un rayonnement UVA.

Les manchons sont fixés sur des axes (11) permettant leur maintien en rotation et leur transfert au cours des différentes étapes de la fabrication des manchons d'impression (10).

Ces axes permettent de transporter des manchons d'impression (10) de tout diamètre, lesdits manchons allant d'un diamètre extérieur de 50 mm à 360 mm et de n'importe quelle longueur.

Ces axes permettent le transfert automatique et l'introduction l'un après l'autre des manchons à l'intérieur d'un sas anti-vapeur de solvant (2).

Les manchons d'impression sont ensuite transférés par les axes vers un dispositif de gravure (3) comportant essentiellement des moyens d'aspiration évacuant les vapeurs de solvant, des brosses (3a) pour la gravure, des moyens de vidange du solvant chargés de photopolymère, un bac de gravure, des moyens de vidange du solvant, une arrivée de solvant propre dans un bac de gravure.

Au niveau du dispositif de gravure, les moyens s'exerçent comme indiqué ci-après :

Les manchons d'impression descendent vers les brosses de gravure (3a) puis le solvant de gravure arrive et les brosses de gravure (3a) se mettent en rotation. La gravure automatique est préalablement programmée suivant le type de plaque ou de cliché photopolymère à traiter.

Les manchons d'impression s'écartent des brosses pour permettre l'arrivée du solvant propre dans le bac de gravure et le nettoyage des brosses par barbotage.

Les manchons redescendent vers les brosses afin de les toucher pour le nettoyage des plaques ou des clichés photopolymères avec le solvant propre.

Les manchons d'impression sont ensuite essorés par le montage d'une brosse.

Les manchons d'impression reviennent ensuite à leur position initiale dans le dispositif de gravure.

Des moyens d'aspiration sont mis en route pour évacuer la vapeur de solvant et une vidange du bac de gravure est effectuée.

Le manchon d'impression est alors transféré vers le poste suivant.

Selon un mode de réalisation préféré, le dispositif suivant l'invention comporte en aval du dispositif de gravure (3) une chambre de contrôle des manchons d'impression comportant un tiroir (4a) pour extraire les manchons d'impression et comportant des moyens d'aspiration.

Ainsi, il est possible de faire sortir sur le côté le manchon d'impression monté sur le tiroir (4a) et de contrôler par exemple visuellement de façon très pratique la qualité de la gravure.

Le manchon d'impression est remis dans le dispositif pour la continuation du procédé par simple fermeture du tiroir (4c).

Le manchon est ensuite transféré vers le dispositif de séchage : ledit dispositif de séchage étant formé principalement d'un four de séchage (5a) équipé d'un carrousel (5b) pour manchons et d'un dispositif de soufflage d'air chaud et comportant également un automate permettant de déterminer le temps de séchage par rapport au type de manchon d'impression.

Ce four "dynamique" permet de sécher à une température de 60° +/-2° les clichés photopolymères flexographiques ou offset fixés sur les manchons.

Le séchage du polymère est très rapide par les effets conjugués de la rotation du carrousel et du dispositif de soufflage d'air chaud à une vitesse très élevée (2 à 8 mètres / seconde).

Après son passage dans le dispositif de séchage, le manchon est éjecté soit vers un poste de stockage, soit vers un poste de finition.

Le poste de finition (6) comporte des tubes (6a,6b) UVA et UVC placés au-dessus et au-dessous du manchon d'impression, les tubes UVA et UVC étant mobiles verticalement grâce à des moyens permettant la mise à distance automatique desdits tubes (6a,6b) UVA et UVC par rapport au diamètre extérieur du manchon.

Le manchon est simultanément en rotation autour de son axe pour permettre une insolation de finition uniforme.

Il faut noter que le passage dans le poste de finition peut se faire séparément et non en ligne automatique étant donné que la plaque est sèche et sans émanation des vapeurs de solvant.

Des moyens automatiques permettent de gérer tous les temps d'exposition de la finition du manchon (l'allumage programmé des tubes (6a,6b) UVA et UVC).

Un automate permet de gérer tous les temps d'exposition pour une parfaite finition des manchons.

En outre, chaque poste du dispositif tel que décrit précédemment est séparé du suivant par différents volets (12 à 16) permettant de rendre hermétique chaque poste et d'avoir une meilleure évacuation des vapeurs de solvant.

Schématiquement, on peut résumer le procédé automatique suivant l'invention comme suit :
- chargement des manchons montés sur axe expansible, ces manchons supportant la plaque photopolymère ayant été préalablement exposée aux rayons UVA,
- entrée d'un manchon dans la chambre d'isolation des vapeurs de solvant,
- passage automatique dans la section de gravure par brosses rotatives. Réglage automatique des brosses suivant le diamètre des manchons et le type de photopolymères. La gravure, le rinçage et l'essorage se feront automatiquement,
- poste intermédiaire permettant de contrôler le manchon après gravure à la demande ou d'extraire un manchon à la demande,
- passage dans le four dynamique à air chaud pulsé. La grande vitesse de l'air chaud permet des temps de séchage très courts du photopolymère,
- passage dans le poste de finition caractérisé par une insolation aux rayons UVC et UVA du photopolymère suivant le diamètre du manchon. Les tubes seront toujours à la même distance de la surface du manchon afin de mieux programmer les temps d'exposition,
- sortie automatique des manchons finis qui sont prêts à être montés sur les cylindres de la rotative.

Un automate programmable permet de programmer toutes les étapes de la fabrication des manchons d'impression en automatique, sans l'intervention de l'opérateur.

Ainsi le dispositif tel qu'il est conçu permet à l'opérateur de charger sa machine de manchons au départ du processus et de partir. Le lendemain matin, il trouvera les huit manchons terminés et prêts à monter sur cylindres des rotatives d'impression pour une utilisation flexographique ou en offset sec.

A titre d'exemple le procédé et le dispositif suivant l'invention permettent de confectionner un manchon d'impression en environ une demi-heure, là où un système traditionnel mettrait six heures.

## Revendications

1. Dispositif pour la fabrication de clichés photopolymères montés sur cylindres, définis par manchons d'impression, pour la réalisation d'impression en flexographie et en offset sec, comportant les postes suivants,
- un magasin de stockage (1) qui reçoit des manchons d'impression préalablement exposés à un rayonnement UVA,
- un dispositif de gravure (3),
- un dispositif de séchage (5),
- un poste de stockage (7) des manchons d'impression terminés,
**caractérisé en ce qu'**il comporte en outre disposés l'un après l'autre en ligne, d'une part en amont du poste de gravure - un sas anti-vapeur de solvant (2), et d'autre part des axes (11) où sont fixés les manchons d'impression, lesdits axes (11) permettant leur maintien en rotation durant les différentes étapes de leur fabrication des manchons d'impression et leur transfert et ce quelque soit leur diamètre et leur longueur.

2. Dispositif selon la revendication 1, **caractérisé en ce qu'**il comporte un poste de finition (6) constitué de tubes (6a,6b) UVA et UVC placés au-dessus et au-dessous du manchon d'impression, dans lequel le manchon est en rotation autour de son axe (11) afin de permettre une insolation uniforme.

3. Dispositif selon la revendication 2, **caractérisé en ce que** lesdits tubes (6a,6b) sont mobiles verticalement grâce à des moyens permettant la mise à distance automatique des tubes par rapport au diamètre extérieur du manchon et ce afin de mieux programmer les temps d'exposition des manchons.

4. Dispositif selon l'une quelconque des revendications précédentes, **caractérisé en ce qu'**il comporte en aval du dispositif de gravure (3), une chambre de contrôle des manchons d'impression comportant un tiroir (4a) pour extraire les manchons d'impression et comportant des moyens d'aspiration.

5. Dispositif selon l'une quelconque des revendications précédentes, **caractérisé en ce que** le dispositif de gravure (3) comporte notamment des moyens d'aspiration évacuant les vapeurs de solvant, des brosses (3a) pour la gravure, des moyens de vidange du solvant chargés de photopolymère, un bac de gravure, des moyens de vidange du solvant, une arrivée de solvant propre dans un bac de gravure.

6. Dispositif selon l'une quelconque des revendications précédentes, **caractérisé en ce que** le dispositif de séchage (5) consiste en un four de séchage (5a) équipé d'un carrousel (5b) pour manchons et d'un dispositif de soufflage d'air chaud et comportant également un automate permettant de déterminer le temps de séchage par rapport au type de manchon d'impression.

7. Dispositif selon l'une quelconque l'une des revendications précédentes, **caractérisé en ce que** chaque poste du dispositif est séparé du suivant par différents volets permettant de rendre hermétique les uns des autres lesdits postes et d'avoir une meilleure évacuation des vapeurs de solvant.

8. Procédé pour la fabrication de clichés photopolymères préalablement exposés à un rayonnement UVA et montés sur des cylindres d'impression, l'ensemble (clichés photopolymères + cylindres d'impression) étant appelé manchon d'impression, pour la réalisation d'impression en flexographie et en offset sec, ledit procédé comportant les étapes suivantes séquentiellement:
- une étape d'aspiration des vapeurs de solvants,
- une étape de gravure par brossage et trempage dans un solvant ou un mélange d'eau plus additif,
- une étape de séchage par passage dans un four dynamique à air chaud pulsé,
**caractérisé en ce qu'**il comporte en outre un transfert de manchon entre deux étapes successives et une étape de finition par exposition à des rayonnements UVA et UVC, consistant à placer au-dessus et au-dessous du manchon d'impression les rayonnements et simultanément mettre en rotation autour de son axe (11) le manchon.

## Patentansprüche

1. Vorrichtung zum Herstellen von Photopolymerdruckstöcken, die auf Zylinder montiert werden, definiert durch Druckhülsen zum Herstellen von Flexographie- und Trockenoffsetdruck mit den folgenden Stationen:
- ein Lagermagazin (1), das die zuvor einer UVA-Strahlung ausgesetzten Druckhülsen aufnimmt,
- eine Gravurvorrichtung (3),
- eine Trockenvorrichtung (5),
- eine Lagerstation (7) der fertigen Druckhülsen,
**dadurch gekennzeichnet, dass** sie ferner, nacheinander in Linie angeordnet, einerseits stromaufwärts des Gravurpostens eine Lösemitteldampfschutzschleuse (2) und andererseits Achsen (11) umfasst, auf welchen die Druckhülsen befestigt sind, wobei diese Achsen (11) das Indrehunghalten der Druckhülsen während der verschiedenen Schritte ihrer Herstellung und ihres Transfers erlauben, und dies ungeachtet ihres Durchmessers und ihrer Länge.

2. Vorrichtung nach Anspruch 1, **dadurch gekennzeichnet, dass** sie eine Endfertigungsstation (6) umfasst, die aus UVA- und UVC-Röhren (6a, 6b) besteht, die über und unter der Druckhülse angeordnet sind, bei der die Hülse um ihre Achse (11) dreht, um eine gleichförmige Bestrahlung zu erlauben.

3. Vorrichtung nach Anspruch 2, **dadurch gekennzeichnet, dass** die Röhren (6a, 6b) dank Mitteln senkrecht beweglich sind, die das automatische Entfernen der Röhren in Bezug auf den Außendurchmesser der Hülse erlauben, und dies, um die Expositionszeiten der Hülsen besser zu programmieren.

4. Vorrichtung nach einem der vorhergehenden Ansprüche, **dadurch gekennzeichnet, dass** sie stromabwärts der Gravurvorrichtung (3) eine Prüfkammer der Druckhülsen umfasst, die einen Schieber (4a) umfasst, um die Druckhülsen herauszuziehen, und der Absaugmittel umfasst.

5. Vorrichtung nach einem der vorhergehenden Ansprüche, **dadurch gekennzeichnet, dass** die Gravurvorrichtung (3) insbesondere Absaugmittel umfasst, die die Lösemitteldämpfe evakuieren, Bürsten (3a) für die Gravur, Mittel zum Entleeren des mit Photopolymer belasteten Lösemittels, einen Gravurbehälter, Mittel zum Entleeren des Lösemittels, eine Zuführung sauberen Lösemittels in einen Gravurbehälter.

6. Vorrichtung nach einem der vorhergehenden Ansprüche, **dadurch gekennzeichnet, dass** die Trockenvorrichtung (5) aus einem Trockenofen (5a) besteht, der mit einem Karussell (5b) für Hülsen versehen ist, und mit einer Vorrichtung zum Blasen heißer Luft, und auch einen Automaten umfasst, der es erlaubt, die Trockenzeit in Bezug auf den Druckhülsentyp zu bestimmen.

7. Vorrichtung nach einem der vorhergehenden Ansprüche, **dadurch gekennzeichnet, dass** jede Station der Vorrichtung von der nächsten durch verschiedene Klappen getrennt ist, die es erlauben, die Stationen voneinander hermetisch zu machen und über eine bessere Ableitung der Lösemitteldämpfe zu verfügen.

8. Verfahren zum Herstellen von Photopolymerdruckstöcken, die zuvor einer UVA-Strahlung ausgesetzt werden und auf Druckzylinder montiert sind, wobei die Einheit (Photopolymerdruckstöcke + Druckzylinder) Druckhülse genannt wird, zum Herstellen von Flexographie- und Trockenoffsetdruck, wobei das Verfahren sequenziell die folgenden Schritte umfasst:
- einen Absaugschritt der Lösemitteldämpfe,
- einen Gravurschritt durch Bürsten und Eintauchen in ein Lösemittel oder ein Gemisch aus Wasser und Zusatzstoff,
- einen Trockenschritt durch Durchlaufen eines dynamischen Ofens mit pulsierter Heißluft,
**dadurch gekennzeichnet, dass** es ferner einen Hülsentransfer zwischen zwei aufeinander folgenden Schritten und einen Endfertigungsschritt durch Exposition mit UVA- und UVC-Strahlungen umfasst, der darin besteht, über und unter die Druckhülse Strahlungen zu platzieren und die Hülse gleichzeitig um ihre Achse (11) in Drehung zu versetzen.

## Claims

1. Apparatus for manufacturing photopolymeric blocks mounted on cylinders, defined by printing sleeves, for producing printing by flexography and by dry offset, comprising the following stations,
- a storage magazine (1), which accommodates printing sleeves previously exposed to UVA radiation,
- an engraving apparatus (3),
- a drying apparatus (5), and
- a station (7) for storing finished printing sleeves,
**characterised in that** it comprises, in addition, disposed one after the other in a line, upstream of the engraving station, a solvent anti-vapour chamber (2) on the one hand and, on the other hand, spindles (11) to which are secured the printing sleeves, said spindles (11) permitting the printing sleeves to be kept in rotation during the various steps of their manufacture and their transfer, this applying whatever their diameter and their length.

2. Apparatus according to claim 1, **characterised in that** it comprises a finishing station (6) made up of UVA and UVC tubes (6a, 6b) placed above and below the printing sleeve, in which the sleeve is in rotation about its spindle (11) in order to permit uniform insulation.

3. Apparatus according to claim 2, **characterised in that** said tubes (6a, 6b) are vertically displaceable, thanks to means which permit the tubes to be automatically positioned relative to the external diameter of the sleeve, this being in order to program the exposure times of the sleeves better.

4. Apparatus according to any one of the preceding claims, **characterised in that** it comprises, downstream of the engraving apparatus (3), a chamber for monitoring the printing sleeves, said chamber comprising a withdrawing means (4a) for extracting the printing sleeves and including suction means.

5. Apparatus according to any one of the preceding claims, **characterised in that** the engraving apparatus (3) comprises, more especially, suction means which remove the solvent vapours, brushes (3a) for the engraving, means for emptying the solvent which are charged with photopolymer, an engraving tank, means for emptying the solvent, and an inlet for clean solvent into an engraving tank.

6. Apparatus according to any one of the preceding claims, **characterised in that** the drying apparatus (5) consists of a drying oven (5a), fitted with a carousel (5b) for sleeves and with an apparatus for blowing hot air, and also comprising an automaton, which permits the drying time to be determined relative to the type of printing sleeve.

7. Apparatus according to any one of the preceding claims, **characterised in that** each station of the apparatus is separated from the following station by different shutters, which permit said stations to be sealed hermetically from one another and to have better evacuation of the solvent vapours.

8. Method of manufacturing photopolymeric blocks previously exposed to UVA radiation and mounted on printing cylinders, the assembly (photopolymeric blocks + printing cylinders) being called a printing sleeve, for producing printing by flexography and by dry offset, said method sequentially comprising the following steps:
- a suction step for drawing the solvent vapours,
- an engraving step by brushing and immersing in a solvent or a more additive water mixture, and
- a drying step by passing into a dynamic oven with pulsed hot air,
**characterised in that** it comprises, in addition, a transfer of the sleeve between two successive steps and a finishing step, by exposure to UVA and UVC radiation, consisting of placing the radiation above and below the printing sleeve and simultaneously setting the sleeve in rotation about its spindle (11).
